# FASCICULE DE BREVET EUROPEEN

(11) **EP 0 786 801 B1**
(45) Date de publication et mention de la délivrance du brevet: **18.06.2003**
(21) Numéro de dépôt: 97400151.3
(22) Date de dépôt: 23.01.1997
(51) Int. Cl.: H01L 21/20, H01L 21/762

(54) **Procédé de transfert d'une couche mince d'un substrat initial sur un substrat final**
Verfahren zum Transportieren einer dünnen Schicht von einem Anfangssubstrat auf ein Endsubstrat
Process for transferring a thin film from an initial substrate to a final substrate

(30) Priorité: 25.01.1996 FR 9600852
(43) Date de publication de la demande: 30.07.1997
(73) Titulaire: COMMISSARIAT A L'ENERGIE ATOMIQUE, 75015 Paris Cédex 15 (FR)
(72) Inventeur: Biasse, Béatrice, 38410 Uriage (FR); Bruel, Michel, 38113 Veurey (FR); Zussy, Marc, 38700 La Tronche (FR)
(74) Mandataire: Poulin, Gérard

(56) Documents cités:
- EP-A- 0 533 551
- EP-A- 0 665 587
- EP-A- 0 703 609
- US-A- 5 362 682
- HAMAGUCHI T ET AL: "Device layer transfer technique using chemi-mechanical polishing" , JAPANESE JOURNAL OF APPLIED PHYSICS, PART 2 (LETTERS), OCT. 1984, JAPAN, VOL. 23, NR. 10, PAGE(S) L815 - L817 , ISSN 0021-4922 XP002017016 * figure 2 *

## Description

### Domaine technique

La présente invention se rapporte à un procédé de transfert d'une couche mince d'un substrat initial sur un substrat final.

On entend par couche mince une couche dont l'épaisseur est de l'ordre de quelques micromètres et dont le diamètre, ou une autre dimension, peut atteindre 100 mm ou plus.

Le transfert de couches minces trouve des applications en particulier dans la réalisation de dispositifs de microélectronique.

Le procédé peut être utilisé, par exemple, pour transférer des couches minces de semi conducteur monocristallin, comportant des circuits électroniques, sur une plaque de verre telle qu'une plaque d'un écran d'affichage plat à matrice active.

Une autre application du transfert de couches minces peut être la fabrication de structures tridimensionnelles de circuits intégrés.

### Etats de la technique antérieure

Une couche mince, au sens de la présente invention ne peut, en raison de ses dimensions et de sa trop grande fragilité être transportée telle quelle.

Aussi, pour transporter la couche, et en particulier la transférer d'un substrat initial à un substrat final, il faut la rendre solidaire d'un substrat de transfert qui présente une épaisseur de plusieurs centaines de microns.

Un tel substrat permet alors de manipuler la couche mince. Il joue en quelque sorte le rôle d'une "poignée" et sera désigné dans la suite du texte par "substrat poignée".

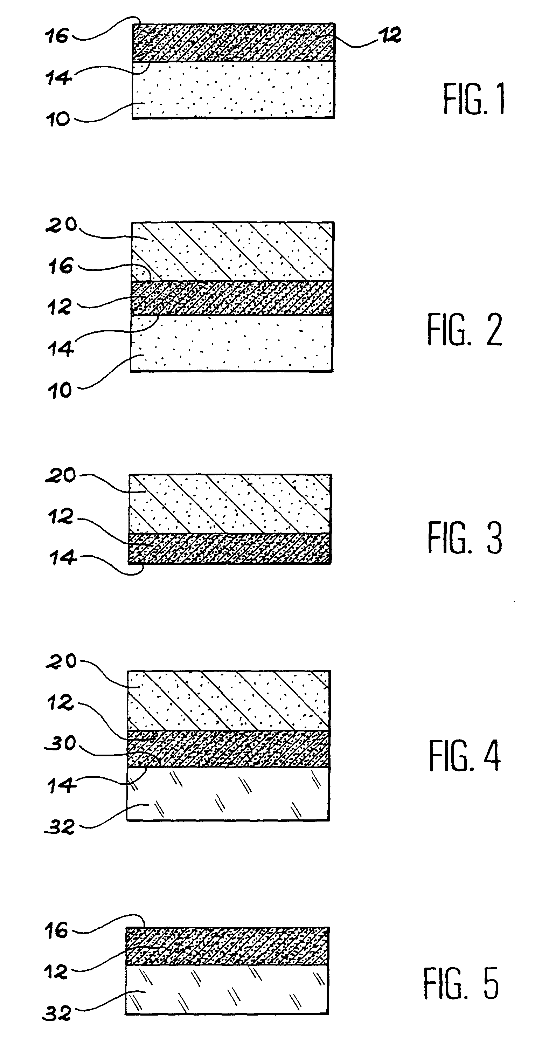

Les figures 1 à 5 illustrent un procédé connu de transfert d'une couche mince d'un substrat initial à un substrat final sans retournement de la couche mince.

La figure 1 montre le substrat initial 10 et la couche mince 12.

La couche mince dans laquelle on a fabriqué, par exemple des circuits électroniques, est solidaire du substrat 10 par une première face 14. Une deuxième face 16 de la couche mince 12, opposée à la première face 14, est libre.

Un substrat poignée 20 est collé sur la deuxième face 16 de la couche mince pour obtenir la structure de la figure 2.

Les figures 3 et 4 montrent successivement l'élimination du substrat initial 10 et le collage de la première face de la couche mince 12 sur une face 30 d'un substrat final 32.

Le substrat initial est éliminé, par exemple, par abrasion mécanique.

Enfin, une dernière étape du procédé connu, représentée à la figure 5, consiste à éliminer le substrat poignée.

Le substrat poignée est totalement détruit par abrasion mécanique ou par attaque chimique. Il peut également être éliminé par combinaison de ces deux moyens. On obtient la structure de la figure 5 avec le substrat final 32 et la couche mince 12.

Au sujet de ce procédé et de l'élimination du substrat poignée on peut se reporter, par exemple, au document (1) dont la référence est indiquée à la fin de la présente description.

Le procédé décrit ci-dessus présente cependant un certain nombre de limitations.

En effet, l'abrasion mécanique du substrat poignée, dont l'épaisseur peut être de l'ordre de 500 µm ou plus, nécessite souvent plusieurs heures de traitement. Or, un tel traitement est susceptible d'endommager la couche mince et/ou les circuits qui y sont réalisés.

Par ailleurs, le substrat poignée est détruit lors de son élimination. Il ne peut donc pas être réutilisé pour une autre opération de transfert.

Un but de la présente invention est de proposer un procédé de transfert sans retournement d'une couche mince, à l'aide d'un substrat poignée dans lequel le substrat poignée n'est pas détruit, mais peut être réutilisé.

Un autre but de la présente invention est de proposer un procédé de transfert d'une couche mince dans lequel la couche mince ne subit pas de contrainte importante lors de l'élimination du support poignée.

Un autre procédé connu pour transférer une couche mince d'un substrat initial à un substrat final est illustré par le document (4) ci-dessous.

### Exposé de l'invention

Pour atteindre les buts mentionnés, l'invention à plus spécialement pour objet un procédé de transfert d'une couche mince d'un substrat initial sur un substrat final par l'intermédiaire d'un substrat dit substrat poignée, la couche mince présentant une première face solidaire du substrat initial et une deuxième face, opposée, libre. Le procédé comporte les étapes successives indiquées dans la revendication 1.

La couche mince peut contenir des éléments actifs. Dans ce cas, cette couche est en matériau semiconducteur et les éléments actifs sont réalisés avant l'étape de solidarisation avec le substrat poignée.

Le clivage permet ainsi d'éliminer la partie massive du substrat poignée. Il ne reste sur la deuxième face de la couche mince que la couche superficielle du substrat poignée. Cette couche superficielle, très fine, peut, dans certains cas, être laissée en place sur la couche mince. Elle peut jouer alors le rôle d'une couche de passivation de la couche mince, par exemple.

Il est possible aussi d'éliminer la couche superficielle par gravure ou toute autre technique adaptée.

Ainsi, grâce au procédé de l'invention, la couche mince ne subit pas de contrainte importante. En particulier, elle ne subit pas les contraintes d'un traitement d'abrasion mécanique.

La solidarisation entre la couche mince et le substrat poignée, de même que la solidarisation de la couche mince sur le substrat final peuvent être réalisés soit par un collage adhésif utilisant une colle, soit par un collage direct, c'est-à-dire sans composé adhésif. Ces opérations sont expliquées plus en détail dans la suite de la description.

Selon un autre aspect de l'invention, l'élimination du substrat initial peut se faire par détachement de ce substrat de la couche mince ou par destruction du substrat.

D'autres caractéristiques et avantages de la présente invention ressortiront mieux de la description qui va suivre, en référence aux figures des dessins annexés, donnée à titre purement, illustratif et non limitatif.

### Brève description des figures

- les figures 1 à 5 sont des coupes schématiques de structures comprenant une couche mince et illustrent différentes étapes d'un procédé connu de transfert d'une couche mince d'un substrat initial vers un substrat final,
- la figure 6A est une coupe schématique d'un substrat dit substrat poignée tel qu'utilisé dans le procédé de l'invention,
- la figure 6B est une coupe schématique d'une structure comportant le substrat initial et une couche mince, telle qu'utilisée dans le procédé de l'invention, et
- les figures 7 à 10 sont des coupes schématiques de structures comportant la couche mince et illustrant des étapes du procédé de l'invention.

### Exposé de modes de mise en oeuvre de l'invention

Des éléments des figures 6A, 6B et 7 à 10, identiques ou similaires à des éléments des figures 1 à 5, portent, dans la suite de la description, des références identiques auxquelles on a ajouté la valeur 100.

Comme le montre la figure 6A, le substrat poignée 120 utilisé dans le procédé de l'invention présente une partie massive 122 et une couche superficielle 124. La partie massive et la couche superficielle sont séparées par une zone de clivage 126.

La zone de clivage est obtenue, par exemple, par implantation à travers une face 128 du substrat 120 d'ions hydrogène H⁺ à une dose supérieure à 3.10¹⁶cm⁻² et une énergie inférieure à 50 keV. Ces ions implantés forment, à la profondeur moyenne de pénétration des ions, une couche de microbulles gazeuses qui définit la zone de clivage 126.

Lorsque le substrat poignée 120 est en silicium, avec les valeurs indiquées pour la dose et l'énergie d'implantation, la zone de clivage est située à une profondeur de l'ordre de 0,5 µm de la face 128 du substrat. Ceci correspond donc à l'épaisseur de la couche superficielle 124.

Pour la réalisation d'une zone de clivage par implantation ionique d'ions de gaz rare ou d'hydrogène, dans un substrat, on peut se reporter au document (2) dont la référence est indiquée à la fin de la présente description.

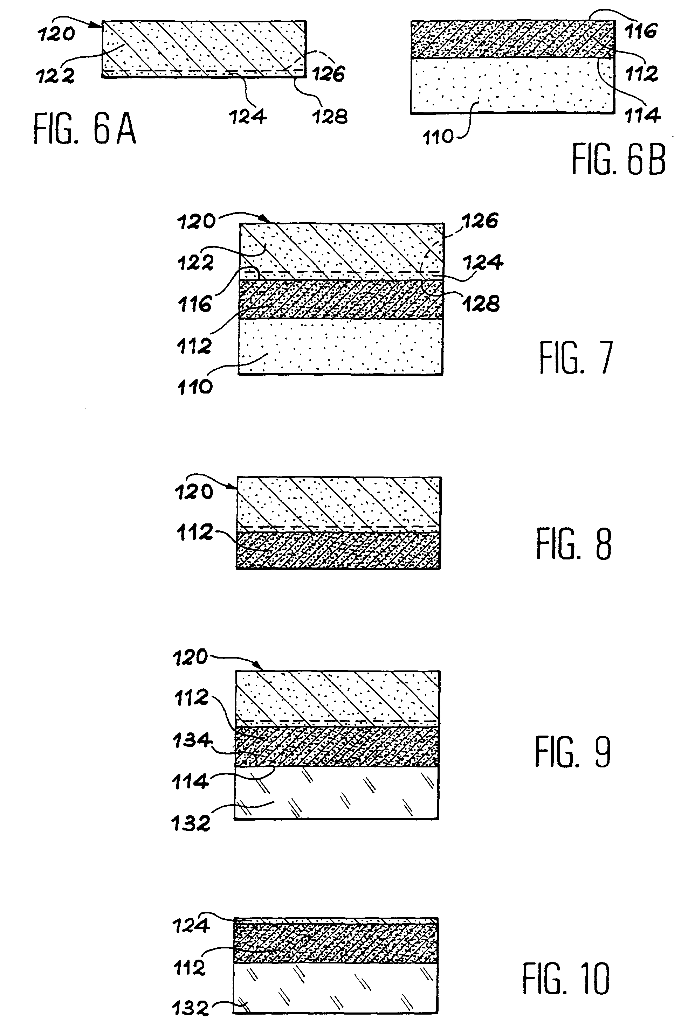

La figure 6B montre le substrat initial 110 et la couche mince. Elle est semblable à la figure 1 déjà décrite. La couche mince présente une première face 114 solidaire du substrat et une deuxième face 116, libre.

La structure formée du substrat initial 110 et de la couche mince peut être une structure de type SOI (silicium sur isolant). Elle comporte alors une fine couche de silicium contenant éventuellement des circuits intégrés et formant ladite couche mince, une couche d'oxyde de silicium que l'on peut considérer comme faisant partie également de la couche mince, et une partie massive de silicium qui constitue le substrat initial.

La figure 7 illustre l'étape de solidarisation du substrat poignée 120 sur la structure comprenant le substrat initial 110 et la couche mince 112.

La couche superficielle 124 du substrat 120 est collée sur la face 116 de la couche mince.

Le collage peut être adhésif, c'est-à-dire un collage par l'intermédiaire d'une colle d'un type résistant à des températures élevées.

Le collage peut aussi être direct. Dans ce cas, on effectue une préparation des faces 116 et 128 par polissage mécanochimique et/ou nettoyage chimique.

Les surfaces ainsi préparées sont mises en contact et la structure obtenue est recuite sous atmosphère d'azote.

La température du recuit est choisie de façon à obtenir une bonne tenue mécanique de l'ensemble formé par le substrat poignée et la couche mince. Elle est toutefois choisie suffisamment basse pour ne pas dégrader d'éventuels circuits intégrés formés dans la couche mince. Par exemple, si la couche mince contient des parties conductrices en aluminium, il convient que la température de recuit n'excède pas 450°C.

De la même façon, il convient de choisir la température de recuit de telle façon qu'elle ne provoque pas un clivage prématuré du substrat poignée 120. A titre d'exemple, le recuit est réalisé à une température de l'ordre de 350°C.

Une étape suivante du procédé est l'élimination du substrat initial. Elle est illustrée par la figure 8.

Plusieurs possibilités de mise en oeuvre de l'invention peuvent être envisagées pour cette étape.

Lorsque la solidarisation du substrat poignée avec la couche mince est réalisée avec une énergie de liaison supérieure à l'énergie de liaison entre la couche mince et le substrat initial, on peut détacher le substrat initial par arrachement.

A cet effet, on exerce sur le substrat initial et le substrat poignée des forces de traction opposées aptes à provoquer un arrachement du substrat initial selon la première face de la couche mince.

Selon une variante de mise en oeuvre de l'invention, on peut prévoir dans le substrat initial, une couche de matériau sacrificiel. Cette couche est de préférence prévue sur la face du substrat initial en contact avec la première face 114 de la couche mince, c'est-à-dire à l'interface substrat initial-couche mince.

L'élimination par voie chimique de cette couche sacrificielle permet de libérer le substrat initial qui peut éventuellement être réutilisé. On peut à ce sujet se reporter au document (3) dont la référence est indiquée à la fin de la présente description.

Selon une autre variante, le substrat initial peut aussi être totalement détruit par abrasion mécanique, par attaque chimique ou encore par combinaison de ces deux moyens.

A titre d'exemple, lorsque le substrat initial est du type silicium sur isolant, son élimination comporte une abrasion mécanique, c'est-à-dire un rodage ou une rectification de la partie massive de silicium. Ensuite, une attaque chimique par TMAH (Tetra Methyl Ammonium Hydroxyde) permet d'éliminer l'épaisseur restante de silicium qui est de l'ordre de quelques dizaines de microns. Lors de cette attaque chimique, la couche d'oxyde de silicium de la structure SOI sert de couche d'arrêt de gravure.

La figure 9 montre la structure obtenue après solidarisation de la première face 114 de la couche mince avec la face superficielle 134 du substrat final 132. Le substrat final 132 est par exemple une plaque de verre. De même que pour la solidarisation du substrat poignée sur la couche mince, il est possible pour la solidarisation avec le substrat final de réaliser soit un collage adhésif avec de la colle soit un collage direct.

Le collage direct comporte la préparation des faces 114 et 134 par polissage mécanochimique et/ou nettoyage chimique, la mise en contact de ces surfaces et, éventuellement un recuit sous atmosphère d'azote de la structure ainsi obtenue.

Le recuit, effectué à une température de l'ordre de 350°C, permet d'améliorer l'adhérence.

Une étape suivante du procédé de l'invention est l'élimination du substrat poignée qui s'effectue par clivage dans la zone de clivage 126 (voir figure 6A).

Le clivage du substrat poignée est provoquée par un traitement thermique. Ce traitement thermique provoque par un effet de réarrangement cristallin dans le substrat poignée et par un effet de pression dans la couche de microbulles gazeuses une séparation de la partie massive de la couche superficielle. On obtient ainsi la structure représentée à la figure 10 où seule la couche superficielle 124 du substrat poignée reste sur la face 116 de la couche mince.

Le traitement thermique peut être commun avec le recuit correspondant au collage de la couche mince sur le substrat final.

Les conditions du traitement thermique et/ou du recuit de collage, c'est-à-dire leur température et leur durée sont choisies suffisantes pour provoquer le clivage et obtenir une bonne tenue mécanique de la couche mince sur le substrat final.

La température est choisie cependant suffisamment basse pour ne pas dégrader d'éventuels circuits ou dispositifs électroniques formés dans la couche mince.

A titre d'exemple, le traitement thermique peut être effectué à 450°C pendant 30 minutes.

Le clivage peut être complété par une étape de gravure pour éliminer la couche superficielle 124 restant sur la couche mince. Elle peut par exemple être éliminée par une attaque chimique TMAH.

La couche 124 peut aussi, dans certains cas, être préservée comme une couche de passivation de la couche mince.

### DOCUMENTS CITES DANS LA PRESENTE DEMANDE

**1)** Evaluation of cubic (cumulatively bonded IC) devices de Y. HAYASHI, 9th Symposium on future electron devices, November 14-15, 1990, pages 267-272
**2)** FR-A-2 681 472
**3)** FR-A-2 715 503
**4)** US-A-5 362 682

## Revendications

1. Procédé de transfert d'une couche mince (112) d'un substrat initial (110) sur un substrat final (132) par un substrat (120) dit substrat poignée, la couche mince présentant une première face (114) solidaire du substrat initial (110) et une deuxième face (116), opposée, libre, **caractérisé en ce qu'**il comporte les étapes successives suivantes :
- solidarisation de la couche mince par sa face libre (116), avec une couche superficielle (124) du substrat poignée (120), la couche superficielle (124) du substrat poignée étant solidaire d'une partie massive (122) du substrat poignée (120) par l'intermédiaire d'une zone de clivage (126) formée par une couche de microbulles gazeuses,
- élimination du substrat initial (110),
- solidarisation de la première face (114) de la couche mince (112) avec une face (134) du substrat final (132),
- clivage du substrat poignée (120) selon la couche de microbulles gazeuses (126).

2. Procédé selon la revendication 1, **caractérisé en ce que** la couche de microbulles gazeuses est obtenue par une implantation de gaz rares ou d'hydrogène dans le substrat poignée.

3. Procédé selon la revendication 1, **caractérisé en ce qu'**on élimine en outre la couche superficielle (124) du substrat poignée restant en contact avec la deuxième face (116) de la couche mince (112) après clivage.

4. Procédé selon la revendication 1, **caractérisé en ce qu'**on élimine le substrat initial (110) par au moins un moyen choisi parmi l'abrasion mécanique et l'attaque chimique.

5. Procédé selon la revendication 4, **caractérisé en ce qu'**on utilise un substrat initial (110) en silicium, relié à la couche mince (112) par l'intermédiaire d'une couche d'oxyde de silicium et **en ce qu'**on élimine le substrat initial (110) successivement par :
- une abrasion mécanique, et
- une attaque chimique avec arrêt sur la couche d'oxyde de silicium.

6. Procédé selon la revendication 1, **caractérisé en ce qu'**on élimine le substrat initial (110) en le détachant de la couche mince (112) selon sa première face (114).

7. Procédé selon la revendication 6, **caractérisé en ce qu'**on détache le substrat initial (110) en exerçant sur le substrat initial et le substrat poignée (120) des forces de traction opposées aptes à provoquer un arrachement du substrat initial selon la première face (114) de la couche mince (112).

8. Procédé selon la revendication 6, **caractérisé en ce qu'**on détache le substrat initial (110) par élimination d'une couche sacrificielle de surface du substrat initial, en contact avec la première face de la couche mince.

9. Procédé selon la revendication 1, **caractérisé en ce que** la solidarisation de la couche mince (112) sur le substrat poignée (120) comporte :
- le polissage mécanochimique et/ou le nettoyage chimique de la deuxième face (116) de la couche mince (112),
- le polissage mécanochimique et/ou nettoyage chimique d'une face (128) de la couche superficielle (124) du substrat poignée (120),
- mise en contact de la deuxième face (116) de la couche mince (112) et de la face (128) de la couche superficielle (124) du substrat poignée,
- recuit de la structure ainsi obtenue à une température telle que le recuit ne provoque pas un clivage prématuré du substrat poignée.

10. Procédé selon la revendication 1, **caractérisé en ce que** la solidarisation de la couche mince (112) sur le substrat final (132) comporte :
- le polissage mécanochimique et/ou le nettoyage chimique de la première face (114) de la couche mince (112) et de ladite face (134) du substrat final (132),
- la mise en contact desdites faces (114, 134),
- le recuit de la structure ainsi obtenue.

11. Procédé selon la revendication 9 ou 10, **caractérisé en ce que** le recuit est effectué à une température de l'ordre de 350°C.

12. Procédé selon la revendication 1, **caractérisé en ce qu'**au moins l'une des solidarisations de la couche mince (112) sur le substrat poignée (120) et de la couche mince (112) sur le substrat final (132) est un collage adhésif utilisant une colle.

13. Procédé selon la revendication 1, **caractérisé en ce que** le clivage comprend un traitement thermique pour provoquer une séparation de la partie massive (122) et de couche superficielle (124) du substrat poignée (120) selon la couche de microbulles formant la zone de clivage (126).

14. Procédé selon la revendication 10 et la revendication 13, **caractérisé en ce que** le recuit de l'étape de solidarisation de la couche mince (112) sur le substrat final (132) comprend ledit traitement thermique de clivage.

## Patentansprüche

1. Verfahren zum Transportieren einer dünnen Schicht (112) von einem Anfangssubstrat (110) auf ein Endsubstrat (132) mittels eines Griff-Substrat genannten Substrats (120), wobei die dünne Schicht eine erste Fläche (114), fest verbunden mit dem Anfangssubstrat (110), und eine zweite, entgegengesetzte, freie Fläche (116) aufweist,
**dadurch gekennzeichnet, dass** es die folgenden Schritte umfasst:
- Herstellen einer Verbindung der freien Fläche (116) der dünnen Schicht mit einer Oberflächenschicht (124) des Griff-Substrats (120), wobei die Oberflächenschicht (124) des Griffsubstrats durch eine Spaltungszone (126), gebildet durch eine Mikrogasblasen-Schicht, mit einem massiven Teil (122) des Griffsubstrats (120) verbunden ist,
- Eliminieren des Anfangssubstrats (110),
- Herstellen der Verbindung zwischen der ersten Fläche (114) der dünnen Schicht (112) und einer Fläche (134) des Endsubstrats (132),
- Spalten des Griff-Substrats (120) entsprechend der Mikrogasblasen-Schicht (126).

2. Verfahren nach Anspruch 1, **dadurch gekennzeichnet, dass** die Mikrogasblasenschicht in dem Griff-Substrat durch eine Edelgas- oder Wasserstoff-Implantation erzeugt wird.

3. Verfahren nach Anspruch 1, **dadurch gekennzeichnet, dass** man außerdem die Oberflächenschicht (124) des Griff-Substrats, die nach der Spaltung in Kontakt bleibt mit der zweiten Fläche (116) der dünnen Schicht (112), eliminiert.

4. Verfahren nach Anspruch 1, **dadurch gekennzeichnet, dass** man das Anfangssubstrat (110) durch wenigstens ein Mittel eliminiert, ausgewählt zwischen mechanischem Abschleifen und chemischem Angriff.

5. Verfahren nach Anspruch 4, **dadurch gekennzeichnet, dass** man ein Anfangssubstrat (110) aus Silicium verwendet, mit der dünnen Schicht (112) durch eine Siliciumdioxidschicht verbunden, und dadurch, dass man das Anfangssubstrat (110) sukzessive eliminiert durch:
- ein mechanisches Abschleifen, und
- einen chemischen Angriff mit Stopp auf der Siliciumdioxidschicht.

6. Verfahren nach Anspruch 1, **dadurch gekennzeichnet, dass** man das Anfangssubstrat (110) eliminiert, indem man es von der dünnen Schicht (112) von deren ersten Fläche (114) ablöst.

7. Verfahren nach Anspruch 6, **dadurch gekennzeichnet, dass** man das Anfangssubstrat (110) ablöst, indem man auf das Anfangssubstrat (110) und das Griff-Substrat (120) ausreichend große entgegengesetzte Zugkräfte ausübt, um das Anfangssubstrat von der ersten Fläche (114) der dünnen Schicht (112) wegzureißen.

8. Verfahren nach Anspruch 6, **dadurch gekennzeichnet, dass** man das Anfangssubstrat (110) ablöst durch Eliminieren einer Oberflächenopferschicht des Anfangssubstrats, in Kontakt mit der ersten Fläche der dünnen Schicht.

9. Verfahren nach Anspruch 1, **dadurch gekennzeichnet, dass** die Herstellung der Verbindung zwischen der dünnen Schicht (112) und dem Griff-Substrat (120) umfasst:
- mechanisch-chemisches Polieren und/oder chemisches Reinigen der zweiten Fläche (116) der dünnen Schicht (112),
- mechanisch-chemisches Polieren und/oder chemisches Reinigen einer Fläche (128) der Oberflächenschicht (124) des Griff-Substrats (120),
- Herstellen des Kontakts zwischen der zweiten Fläche (116) der dünnen Schicht (112) und der Fläche (128) der Oberflächenschicht (124) des Griff-Substrats,
- Tempern der so erhaltenen Struktur mit einer solchen Temperatur, dass das Tempern keine vorzeitige Spaltung des Griff-Substrats verursacht.

10. Verfahren nach Anspruch 1, **dadurch gekennzeichnet, dass** die Herstellung der Verbindung zwischen der dünnen Schicht (112) und dem Endsubstrat (132) umfasst:
- mechanisch-chemisches Polieren und/oder chemisches Reinigen der ersten Fläche (114) der dünnen Schicht (112) und der genannten Fläche (134) des Endsubstrats (132),
- Herstellen des Kontakts zwischen den genannten Flächen (114, 134),
- Tempern der so erhaltenen Struktur.

11. Verfahren nach Anspruch 9 oder 10, **dadurch gekennzeichnet, dass** das Tempern bei einer Temperatur in der Größenordnung von 350° erfolgt.

12. Verfahren nach Anspruch 1, **dadurch gekennzeichnet, dass** wenigstens eine der Verbindungsherstellungen zwischen der dünnen Schicht (112) und dem Griff-Substrat (120) und der dünnen Schicht (112) und dem Endsubstrat (132) eine Adhäsionsklebung ist, bei der ein Klebstoff verwendet wird.

13. Verfahren nach Anspruch 1, **dadurch gekennzeichnet, dass** die Spaltung eine thermische Behandlung oder Wärmebehandlung umfasst, um eine Trennung des massiven Teils (122) und der Oberflächenschicht (124) von dem Griff-Substrat (120) entsprechend der Mikroblasenschicht zu bewirken, die die Spaltungszone (126) bildet.

14. Verfahren nach Anspruch 10 und Anspruch 13, **dadurch gekennzeichnet, dass** das Tempern des Schritts der Verbindungsherstellung zwischen der dünnen Schicht (112) und dem Endsubstrat (132) die genannte Spaltungs-Wärmebehandlung umfasst.

## Claims

1. Process for transferring a thin film (112) from an initial substrate (110) onto a final substrate (132) by a substrate (120) referred to as handle substrate, the thin film having a first face (114) joined to the initial substrate (110) and a second, opposite, free face (116), **characterized in that** it comprises the following successive stages:
- joining of the thin film by its free face (116) with a superficial film (124) of the handle substrate (120), the superficial film (124) of the handle substrate being joined to a solid part (122) of the handle substrate (120) by the intermediary of a cleavage zone (126) formed by a gaseous microbubble layer,
elimination of the initial substrate (110),
- joining of the first face (114) of the thin film (112) with a face (134) of the final substrate (132),
- cleavage of the handle substrate (120) along the gaseous microbubble layer (126).

2. Process according to claim 1, **characterized in that** the gaseous microbubble layer is obtained by the implantation of rare gases or hydrogen in the handle substrate.

3. Process according to claim 1, **characterized in that** elimination also takes place of the surface layer (125) of the handle substrate remaining in contact with the second face (116) of the thin film (112) after cleaving.

4. Process according to claim 1, **characterized in that** the initial substrate (110) is eliminated by at least one means chosen from among mechanical abrasion and chemical etching.

5. Process according to claim 4, **characterized in that** use is made of an initial silicon substrate (110) connected to the thin film (12) by a silicon oxide film and **in that** the initial substrate (110) is successively eliminated by mechanical abrasion and chemical etching with stoppage on the silicon oxide film.

6. Process according to claim 1, **characterized in that** the initial substrate (110) is eliminated by detaching it from the film thin (112) along its first face (114).

7. Process according to claim 6, **characterized in that** the initial substrate (110) is detached by exerting on said initial substrate and the handle substrate (120) opposing tensile forces able to bring about a tearing of the initial substrate along the first face (114) of the thin film (112).

8. Process according to claim 6, **characterized in that** the initial substrate (110) is detached by the elimination of a sacrificial surface film of the initial substrate in contact with the first face of the thin film.

9. Process according to claim 1, **characterized in that** the joining of the thin film (112) to the handle substrate (120) involves mechanochemical polishing and/or chemical cleaning of the second face (116) of the thin film (112), mechanochemical polishing and/or chemical cleaning of one face (128) of the surface film (112) of the handle substrate (120), contacting the second face (116) of the thin film (112) and the face (128) of the surface film (124) of the handle substrate and annealing the thus obtained structure at a temperature that annealing does not bring about a premature cleaving of the handle substrate.

10. Process according to claim 1, **characterized in that** the joining of the film thin (112) to the final substrate (132) involves mechanochemical polishing and/or chemical cleaning of the first face (114) of the thin film (112) and said face (134) of the final substrate (132), the contacting of said faces (114, 134) and the annealing of the thus obtained structures.

11. Process according to claim 9 or 10, **characterized in that** annealing takes place at a temperature of approximately 350°C.

12. Process according to claim 1, **characterized in that** at least one of the joinings of the thin film (112) to the handle substrate (120) and the thin film (112) to the final substrate (132) is an adhesive attachment using a glue.

13. Process according to claim 1, **characterized in that** cleaving comprises a heat treatment in order to bring about a separation of the solid part (122) and the surface film (124) of the handle substrate (120) along a microbubble layer forming the cleaving zone (126).

14. Process according to claims 10 and 13, **characterized in that** the annealing of the stage of joining the thin film (112) to the final substrate (132) comprises said cleaving heat treatment.
